# EUROPÄISCHE PATENTSCHRIFT

(11) **EP 2 941 759 B1**
(45) Veröffentlichungstag und Bekanntmachung des Hinweises auf die Patenterteilung: **20.10.2021**
(21) Anmeldenummer: 13818672.1
(22) Anmeldetag: 30.12.2013
(51) Int. Cl.: G07D 7/04

(54) **MESSVORRICHTUNG ZUM MESSEN MAGNETISCHER EIGENSCHAFTEN DER UMGEBUNG DER MESSVORRICHTUNG**
MEASURING DEVICE FOR MEASURING MAGNETIC PROPERTIES OF THE SURROUNDINGS OF THE MEASURING DEVICE
DISPOSITIF DE MESURE DES PROPRIÉTÉS MAGNÉTIQUES DE L'ENVIRONNEMENT DU DISPOSITIF DE MESURE

(30) Priorität: 02.01.2013 DE 102013000016
(43) Veröffentlichungstag der Anmeldung: 11.11.2015
(73) Patentinhaber: TE Connectivity Sensors Germany GmbH, 44227 Dortmund (DE)
(72) Erfinder: MEISENBERG, Armin, 44227 Dortmund (DE); BARTOS, Axel, 45731 Waltrop (DE); PIEPER, Reinhold, 59348 Lüdinghausen (DE)
(74) Vertreter: König Szynka Tilmann von Renesse Patentanwälte Partnerschaft mbB
(86) Internationale Anmeldenummer: PCT/EP2013/003923
(87) Internationale Veröffentlichungsnummer: WO 2014/106534

(56) Entgegenhaltungen:
- WO-A1-98/38792
- DE-A1- 2 834 287
- DE-A1-102010 035 469
- DE-A1-102011 106 263
- None

## Beschreibung

Die Erfindung betrifft eine Messvorrichtung zum Messen magnetischer Eigenschaften der Umgebung der Messvorrichtung mit einer Sensorzeile mit mindestens zwei sich in eine Zeilenrichtung erstreckenden Sensorelementen. Ebenso betrifft die Erfindung eine Verwendung einer solchen Messvorrichtung.

Ein mögliches Anwendungsgebiet der Erfindung ist das Prüfen von Scheinen oder Bögen, insbesondere von Geldscheinen, Schecks oder anderen Papierbögen auf das Vorhandensein magnetischer Merkmale, insbesondere daraufhin, ob die Scheine oder Bögen besondere, vorher festgelegte magnetische Merkmale aufweisen. Wertdokumente können weichmagnetische Sicherheitsmerkmale und/oder hartmagnetische Sicherheitsmerkmale aufweisen. Hartmagnetische Sicherheitsmerkmale können aus Werkstoffen mit hoher Remanenz und hoher Koerzitivfeldstärke hergestellt werden. Weichmagnetische Sicherheitsmerkmale können aus Werkstoffen mit hoher Remanenz aber geringer Koerzitivfeldstärke hergestellt werden. Permanentmagneten sind insbesondere aus hartmagnetischen Werkstoffen hergestellt. Weichmagnetische Werkstoffe sind ferromagnetische Materialien, die sich in einem Magnetfeld leicht magnetisieren lassen. Die damit verbundene magnetische Polarisation (Magnetisierung) kann zum Beispiel durch einen elektrischen Strom in einer stromdurchflossenen Spule oder durch Anwesenheit eines Permanentmagneten erzeugt werden. Eine so erzeugte Polarisation führt in einem weichmagnetischen Werkstoff zu einer vielfach höheren magnetischen Flussdichte als das von außen wirkende magnetische Feld in der Luft erzeugt. Weichmagnetische Werkstoffe besitzen in der Regel eine Koerzitivfeldstärke von weniger als 1000 A/m. Weichmagnetische Werkstoffe können allerdings durchaus zu hartmagnetischen Werkstoffen vergleichbare Sättigungsmagnetisierungswerte besitzen, sodass sie im gesättigten Zustand von hartmagnetischen Materialien nicht zu unterscheiden sind.

Zum Nachweis weichmagnetischer Sicherheitsmerkmale in einem Wertdokument muss daher ein externes Magnetfeld vorhanden sein, das die weichmagnetischen Stoffe möglichst sättigt. In aus der Praxis bekannten Messvorrichtungen werden große Magnete verbaut, die ein genügend starkes Feld zur Magnetisierung der weich- und hartmagnetischen Sicherheitsmerkmale erzeugen, aber auch den Aufbau derartiger Messvorrichtungen kompliziert machen. Aus DE 696 08 137 T2 ist es bekannt, einen Lesekopf bereitzustellen, der Magnetisierungsmittel und mindestens ein magnetoresistives Element aufweist, wobei das magnetoresistive Element einen variablen Widerstand hat, der vom an ihn angebrachten magnetischen Fluss abhängig ist. Der dort beschriebene Lesekopf wird derart eingesetzt, dass jedes zu erkennende Wertdokument während der Relativbewegung des Wertdokuments zum Lesekopf zunächst vor dem Magnetisierungsmittel und dann vor besagten magnetoresistiven Element vorbeigeführt wird, wobei das Magnetisierungsmittel so ausgelegt sein kann, dass ein ständiger magnetischer Fluss am Sensorelement anliegt.

Von hartmagnetischen Sicherheitsmerkmalen geht von sich aus und ohne Anwesenheit eines externen Magnetfelds ein Magnetfeld aus, sofern die hartmagnetischen Materialien zuvor vollständig und eindeutig magnetisiert wurden. Dieses Magnetfeld bleibt auch über längere Zeit bestehen. Über die Zeit führen aber statistische Prozesse dazu, dass die hartmagnetischen Materialien entmagnetisiert werden können. Beispielsweise erfahren Geldscheine bei ihrer Handhabung häufig Stöße oder werden geknittert. Dies kann zu einer Entmagnetisierung der hartmagnetischen Materialien führen. Deshalb ist es zum Messen hartmagnetischer Sicherheitsmerkmale zweckmäßig, durch einen Vormagnetisierungsmagneten dem hartmagnetischen Sicherheitsmerkmal eine neue (eindeutige und dauerhafte) Magnetisierung aufzuprägen. Diese neu aufgeprägte Magnetisierung kann das hartmagnetische Sicherheitsmerkmal dann über eine größere Zeitspanne, mindestens über dem Zeitraum der Messung, halten.

Ein besonderes Sicherheitsmerkmal auf Banknoten ist der ferromagnetische Sicherheitsfaden (siehe DE 16 96 245 A1). In der Praxis kommen zur Bildung des Sicherheitsfadens beispielsweise ferromagnetische Materialien zum Einsatz, die aber sowohl eine geringe Koerzitivfeldstärke als auch eine große Koerzitivfeldstärke aufweisen können. Messvorrichtungen zum Prüfen derartiger Banknoten sind in besonders bevorzugter Ausführungsform deshalb dafür ausgelegt, sowohl Sicherheitsfäden aus Material mit geringer, als auch Sicherheitsfäden aus Material mit großer Koerzitivfeldstärke zu erkennen.

Auf diesem Anwendungsgebiet ist es aus der EP 0 977 015 A2 bekannt, eine Messvorrichtung zum Messen magnetischer Eigenschaften der Umgebung der Messvorrichtung mit einer Sensorzeile mit zwei sich in eine Zeilenrichtung erstreckenden Sensorelementen auszustatten. Die Sensorzeile kann die magnetischen Eigenschaften ihrer Umgebung messen. Die dort beschriebene Messvorrichtung weist einen Vormagnetisierungsmagneten auf, der in den Sensorelementen ein magnetisches Feld erzeugt, das im Wesentlichen homogen ist und dessen Feldrichtung im Bereich der Sensorzeile in die Zeilenrichtung weist. Ferner ist bei der dort vorgesehenen Messvorrichtung ein Vormagnetisierungsmagnet vorgesehen. Dieser Vormagnetisierungsmagnet stärkt die hartmagnetischen Sicherheitsmerkmale eines zu überprüfenden Dokuments in der Weise, dass er das von den hartmagnetischen Sicherheitsmerkmalen ausgehende Feld stärkt. Der Vormagnetisierungsmagnet ist beabstandet von der Sensorzeile angeordnet und soll bezüglich der Sensorzeile abgeschirmt werden, sodass das von dem Vormagnetisierungsmagneten erzeugte Magnetfeld nicht auf die Sensorelemente der Sensorzeile einwirkt. Ferner lehrt EP 0 977 015 A2 für die zur Bildung der Sensorelemente einzusetzenden magnetoresistiven Elemente solche zu verwenden, die eine V-förmige Charakteristik ihrer Impedanzvariation im Verhältnis zu Variationen eines externen, in Zeilenrichtung weisenden Feldes aufweisen.

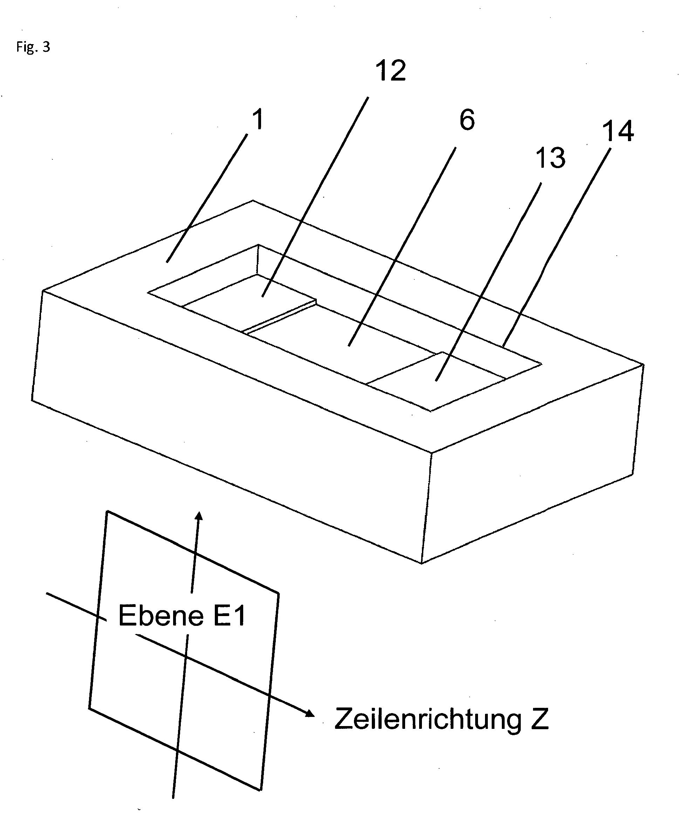

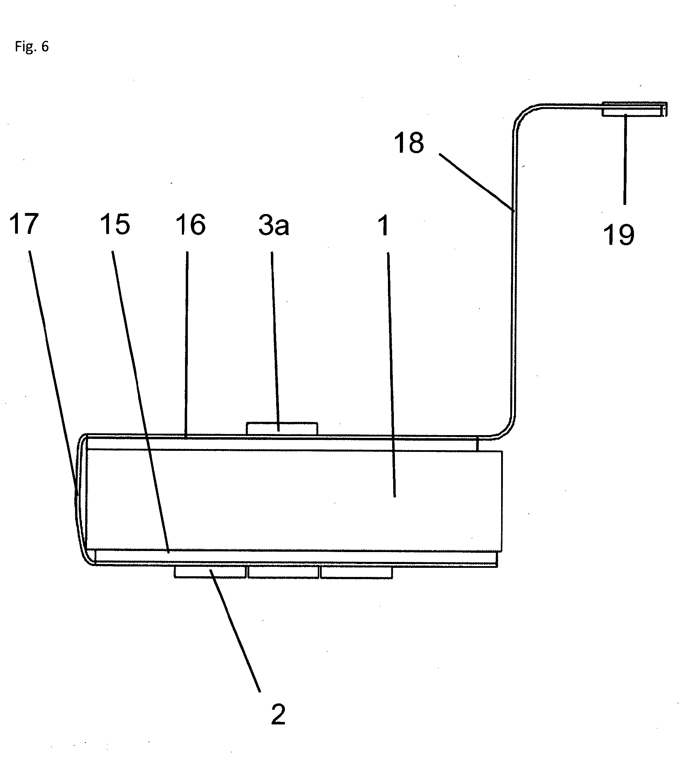

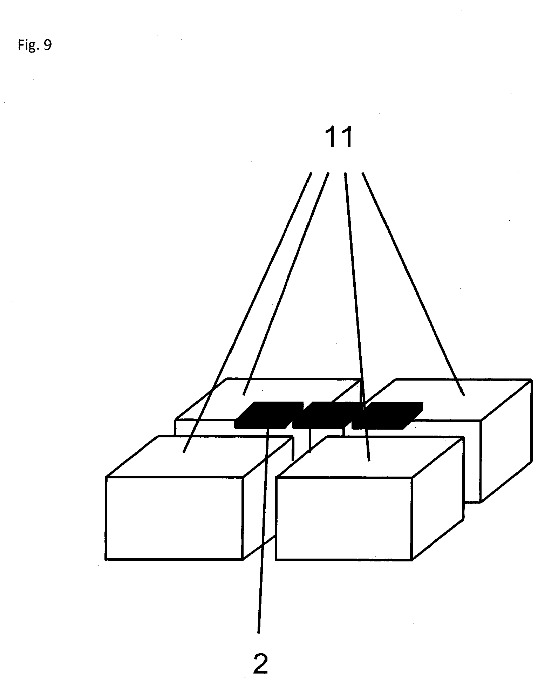

Aus EP 1 701 176 A1 ist eine Messvorrichtung zum Messen magnetischer Eigenschaften der Umgebung der Messvorrichtung mit einer Sensorzeile mit mindestens zwei sich eine Zeilenrichtung erstreckenden Sensorelementen bekannt, bei der die Sensorzeile die magnetischen Eigenschaften ihrer Umgebung messen kann. Bei der aus EP 1 701 176 A1 bekannten Bauform sind jeweils zwei magnetoresistive Abschnitte auf einem magnetoresistiven Element vorgesehen. Die einzelnen magnetoresistiven Elemente sind in einer Reihe angeordnet und bilden die Sensorzeile. Jedes magnetoresistive Element weist einen Stützfeldmagneten auf. Gemäß der in den Figuren 9a und 9b der EP 1 701 176 A1 gezeigten Ausführungsform wird durch die Stützfeldmagneten ein im Wesentlichen homogenes magnetisches Feld erzeugt, dessen Feldrichtung im Bereich der Sensorzeile in einem Winkel von 90° zur Zeilenrichtung ausgerichtet ist. Gemäß den in den Figuren 3a, 3b, den Figuren 4a, 4b, den Figuren 5a, 5b und gemäß dem in der Figur 6 dargestellten Ausführungsbeispielen erzeugen die Stützfeldmagneten ein inhomogenes Feld im Bereich der Sensorzeile.

Ebenso ist es aus WO 2010/006801 A1 bekannt, eine Messvorrichtung zum Messen magnetischer Eigenschaften der Umgebung der Messvorrichtung mit einer Sensorzeile mit mindestens zwei sich in eine Zeilenrichtung erstreckenden Sensorelementen auszubilden, bei denen die Sensorzeile die magnetischen Eigenschaften ihrer Umgebung messen kann. In den Figuren der WO 2010/006801 A1 wird eine Stützfeldvorrichtung gezeigt, die aus einzelnen Magneten besteht und die ein inhomogenes Feld im Bereich der Sensorzeile erzeugen. Die WO 2010/006801 A1 lehrt dabei, den Feldstärkenverlauf in Zeilenrichtung in einer besonderen Weise im Hinblick auf die Sensorelemente einzustellen.

Aus der DE 10 2011 110 138 ist eine Messvorrichtung zum Messen magnetischer Eigenschaften der Umgebung der Messvorrichtung mit einer Sensorzeile mit mindestens zwei sich in eine Zeilenrichtung erstreckenden Sensorelementen bekannt. Mit der Sensorzeile können die magnetischen Eigenschaften der Umgebung der Sensorzeile gemessen werden. Die dort beschriebene Messvorrichtung weist eine Stützfeldvorrichtung auf, die in dem Bereich, über den sich die Sensorzeile erstreckt, ein magnetisches Stützfeld erzeugt. Ferner weist die vorbekannte Messvorrichtung eine Vormagnetisierungsvorrichtung auf, die einen Vormagnetisierungsmagneten oder mehrere Vormagnetisierungsmagneten aufweist, wobei zumindest ein Vormagnetisierungsmagnet in einer zur Zeilenrichtung senkrechten Richtung von der Sensorzeile beabstandet angeordnet ist und sich in einer Richtung parallel zur Zeilenrichtung erstreckt. Die vorbekannte Messvorrichtung schlägt eine besondere Abstimmung der Vormagnetisierungsvorrichtung auf die Stützfeldvorrichtung vor, sodass ein spezielles Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile größer ist als die Stärke der senkrecht zur Zeilenrichtung und nicht in Richtung der Höhe des Sensorelements weisenden Feldkomponente.

Bei den aus WO 2010/006801 A1, DE 10 2011 110 138 A1 und EP 0 977 015 A2 bekannten Messvorrichtungen werden Vormagnetisierungsvorrichtungen und Stützfeldvorrichtungen beschrieben. Dabei ist bei der aus EP 0 977 015 A2 bekannten Bauform die Vormagnetisierungsvorrichtung getrennt von der Stützfeldvorrichtung ausgebildet, wobei die Stützfeldvorrichtung durch einen einzigen Magneten mit einem Nordpol und einem Südpol gebildet wird. Bei der aus WO 2010/006801 A1 bekannten Messvorrichtung weist die Stützfeldvorrichtung eine Zeile in Zeilenrichtung der Sensorelemente nebeneinander angeordneter Magnete auf. Die Magnetisierung der Magnete dieser Zeile kann alternierend sein oder in einer alternativen Ausführungsform so ausgebildet sein, dass die Magnetisierung der einzelnen Magnete der Stützfeldvorrichtung die gleiche Richtung aufweist.

Bei der aus DE 10 2011 110 138 A1 bekannten Messvorrichtung ist eine von der Stützfeldvorrichtung getrennt ausgeführte Vormagnetisierungsvorrichtung vorgesehen. Die Stützfeldvorrichtung kann aus einem oder mehreren Bauteilen, beispielsweise Permanentmagneten bestehen und beispielsweise durch einen Einzelmagneten mit lokal variierender Magnetisierungsverteilung gebildet werden.

Aus DE 10 2010 035 469 A1 ist eine Messvorrichtung zur Prüfung von Wertdokumenten bekannt, die mindestens ein Sensorelement zum Detektieren von Magnetsignalen des Wertdokuments aufweist. Ferner weist die dort beschriebene Messvorrichtung einen Magneten zum Magnetisieren eines durch den Sensor zu prüfenden Wertdokuments auf. Der Magnet ist derart angeordnet, dass bei der Prüfung des Wertdokuments ein magnetischer Pol des Magneten dem Wertdokument zugewandt ist. Der Magnet stellt ein Magnetfeld zum Magnetisieren des Wertdokuments in einer Magnetisierungsrichtung bereit, das bei der Prüfung des Wertdokuments senkrecht zur Wertdokumentebene orientiert ist. Bei dem bekannten Sensor ist auch das magnetoresistive Element in dem Magnetfeld des Magneten angeordnet. Der dem Wertdokument zugewandte magnetische Pol des Magneten weist eine Vertiefung auf. Die Vertiefung ist derart ausgebildet und das magnetoresistive Element relativ zu dem Magneten derart angeordnet, dass das Magnetfeld des Magneten am Ort des magnetoresistiven Elements senkrecht zur einer Empfindlichkeitsrichtung E des magnetoresistiven Elements orientiert ist, entlang der das magnetoresistive Element zum Detektieren von Magnetfeldern ausgebildet ist.

Die aus dem Stand der Technik bekannten Messvorrichtungen sind entweder aufgrund der Vielzahl der einzusetzenden einzelnen Bauelemente, insbesondere wenn eine Mehrzahl von Permanentmagneten einzusetzen ist, in ihrem Aufbau komplex oder aber haben einen verhältnismäßig großen Raumbedarf. Es sind Anwendungsfälle bekannt, bei denen eine Messvorrichtung zum Messen magnetischer Eigenschaften der Umgebung der Messvorrichtung eingesetzt werden soll, die die magnetischen Eigenschaften der Umgebung der Messvorrichtung zuverlässig messen sollen, aber kompakt und/oder einfach aufgebaut sein sollen. Der Erfindung liegt daher die Aufgabe zugrunde, eine eben solche Messvorrichtung vorzuschlagen.

Diese Aufgabe wird durch die im Anspruch 1 beschriebene Messvorrichtung, bzw. durch die im Anspruch 13 beschriebene Verwendung einer solchen Messvorrichtung gelöst. Vorteilhafte Ausführungsformen sind in den Unteransprüchen und der hiernach folgenden Beschreibung wiedergegeben.

Die Erfindung geht von dem Grundgedanken aus, mit einer Magnetisierungsvorrichtung ein magnetisches Feld zu erzeugen, das im Bereich der Sensorzeile im Wesentlichen homogen ist und dessen Feldrichtung im Bereich der Sensorzeile im einem Winkel zwischen 65° und 85° zur Zeilenrichtung weist.

Dies bietet den Vorteil, dass man die Erfindung beispielsweise mit einem einzigen Magneten umsetzen kann, der sowohl als Vormagnetisierungsmagnet als auch als Stützfeldmagnet Wirkung entfaltet. Von der schräg zur Zeilenrichtung verlaufenden Feldrichtung des magnetischen Felds der Magnetisierungsvorrichtung kann die senkrecht zur Zeilenrichtung ausgerichtete Feldkomponente die Vormagnetisierung übernehmen, bzw. die Sättigung der weichmagnetischen Strukturen. Die in Zeilenrichtung weisende Feldkomponente des von der Magnetisierungsvorrichtung erzeugten magnetischen Felds kann die Aufgaben eines Stützfeldmagneten übernehmen. Indem die Erfindung es erlaubt, die Aufgaben des Vormagnetisierungsmagneten und die Aufgaben des Stützfeldmagneten durch einen Magneten zu realisieren, kann die erfindungsgemäße Ausführungsform kompakt und mit wenigen Bauteilen, insbesondere mit wenigen Magneten umgesetzt werden.

Die Erfindung geht von dem Grundgedanken aus, ein im Wesentlichen homogenes Feld im Bereich der Sensorzeile zu erzeugen. Als Bereich der Sensorzeile wird dabei insbesondere der räumliche Bereich verstanden, der die Sensorelemente der Sensorzeile gerade eben noch einschließt.

Die erfindungsgemäße Messvorrichtung ist zum Messen magnetischer Eigenschaften der Umgebung der Messvorrichtung geeignet. Unter magnetischen Eigenschaften der Umgebung der Messvorrichtung werden insbesondere die Magnetfeldstärke eines magnetischen Feldes in der Umgebung der Messvorrichtung, die Feldrichtung eines magnetischen Feldes in der Umgebung der Messvorrichtung oder aber auch beispielsweise die Änderung der Feldstärke, bzw. Feldrichtung eines magnetischen Feldes in der Umgebung der Messvorrichtung verstanden. Beispielsweise wird als magnetische Eigenschaft der Umgebung die Änderung der Feldstärke und der Feldrichtung des die Messvorrichtung umgebenden magnetischen Feldes verstanden, wenn sich dieses Feld durch Überlagerung eines Feldes ändert, das von einem magnetischen Muster einer Banknote erzeugt wird. In einer bevorzugten Ausführungsform wird die Sensorzeile so ausgelegt, dass sie nur räumliche und/oder zeitliche Änderungen der magnetischen Eigenschaften der Umgebung der Messvorrichtung detektiert.

In einer bevorzugten Ausführungsform ist das Sensorelement bzw. eine Verschaltung von Sensorelementen derart ausgebildet, dass es magnetische Eigenschaften der Umgebung der Messvorrichtung, wozu definitionsgemäß auch die Änderung einer Feldstärke gehört, nur in einer als Messrichtung bezeichneten Richtung eines orthogonalen Koordinatensystems messen kann, bzw. in einer alternativen Ausführungsform nur in zwei Richtungen eines orthogonalen Koordinatensystems messen kann, die in einer als Sensormessebene bezeichneten Ebene liegen.

In einer bevorzugten Ausführungsform ist die erfindungsgemäße Messvorrichtung zum Messen magnetischer Strukturen eines Scheins oder eines Bogens, insbesondere eines Geldscheins oder Schecks, ausgebildet und weist geeignete Mittel auf, um den Schein oder den Bogen zumindest in einem der Sensorzeile benachbarten Bereich in einer Messebene an der Sensorzeile vorbei zu bewegen. Dabei wird die Richtung, in die der Schein, bzw. der Bogen bewegt wird, als Leserichtung bezeichnet. Insbesondere bevorzugt ist das Sensorelement derart ausgebildet, dass die Messrichtung der Leserichtung entspricht, das Sensorelement also nur magnetische Eigenschaften seiner Umgebung in Leserichtung messen kann. Ist das Sensorelement, bzw. eine Verschaltung von Sensorelementen derart ausgebildet, dass es magnetische Eigenschaften der Umgebung der Messvorrichtung nur in zwei Richtungen eines orthogonalen Koordinatensystems messen kann, die in einer als Sensormessebene bezeichneten Ebene liegen, ist die Messebene, in der der Schein oder der Bogen an der Sensorzeile vorbeibewegt werden, insbesondere bevorzugt parallel zur Sensormessebene angeordnet.

Bei der erfindungsgemäßen Messvorrichtung ist eine Sensorzeile mit mindestens zwei sich in eine Zeilenrichtung erstreckenden magnetoresistiven Sensorelementen vorgesehen. Das Sensorelement ist zum Messen der magnetischen Eigenschaften in seiner Umgebung so ausgebildet, dass es den "anisotropen" magnetoresistiven Effekt (AMR-Effekt) aufweist.

Ein Sensorelement weist insbesondere bevorzugt vier oder mehrere zu einer Wheatstone-Brücke zusammengeschaltete einzelne Brückenwiderstände oder zwei oder mehrere zu einer halben Wheatstone'schen Brücke zusammen geschaltete einzelne Brückenwiderstände auf. Ein Sensorelement kann aber auch durch einen einzigen Widerstand gebildet werden, wobei bei einer solchen Ausführungsform vorzugsweise mehrere Sensorelemente (einzelne Widerstände) zu einer Wheatstone Brücke oder einer halben Wheatstone'schen Brücke zusammengeschaltet werden.

Das Sensorelement, bzw. mehrere zusammengeschaltete Sensorelemente können in einer bevorzugten Ausführungsform zur Bildung eines Sensors nach dem Gradientenprinzip eingesetzt werden. Bei einem Gradientensensor sind zwei beabstandete Sensorelemente so verschaltet, dass eine lokale Felddifferenz zwischen beiden Sensorelementen ein Messsignal erzeugt, während ein auf beide Sensorelemente gleichermaßen wirkendes Feld keine Signaländerung bewirkt. In einer alternativen Ausführungsform ist das Sensorelement, bzw. sind miteinander zusammengeschaltete Sensorelemente so ausgebildet, dass sie einen Homogenfeldsensor bilden. Bei einem Homogenfeldsensor sind die Sensorelemente derart verschaltet, dass das erzeugte Signal in erster Näherung dem Mittelwert der an den Einzelsensoren wirkenden Feldstärke proportional ist, während lokale Feldunterschiede zwischen den einzelnen Sensorelementen keine Sensorsignale erzeugen. Da ein Homogenfeldsensor im Vergleich zum Gradientensensor in Bewegungsrichtung deutlich kleinere Abmessungen haben kann und die Abmessungen der sensitiven Fläche das Auflösungsvermögen bestimmen, ist mit einem Homogenfeldsensor in der Regel eine höhere Detailauflösung in Bewegungsrichtung realisierbar.

Das Sensorelement weist eine Breite und eine Länge sowie eine Höhe auf, wobei vorzugsweise die Höhe geringer ist als die Breite und die Höhe vorzugsweise geringer ist als die Länge und vorzugsweise die Zeilenrichtung in Richtung der Breite oder in Richtung der Länge des Sensorelements weist.

Die Sensorzeile weist mindestens zwei Sensorelemente auf, die in Zeilenrichtung hintereinander angeordnet sind. Die Länge der Sensorzeile und damit die Zahl der verwendeten magnetoresistiven Sensorelemente hängt von der durchzuführenden Messung ab. Zur Messung von Euro-Banknoten kann eine Sensorzeile beispielsweise mehr als 10, insbesondere bevorzugt mehr als 20, beispielsweise mehr als 31 und bevorzugt 90 Sensorelemente aufweisen, insbesondere wenn die Vorrichtung dafür eingesetzt wird, Euro-Banknoten zu messen, die mit ihrer kurzen Seite in einer Messrichtung relativ zur Messvorrichtung bewegt werden. In einer bevorzugten Ausführungsform sind in Richtung der Sensorzeile jedoch nur 10 oder weniger als 10, insbesondere bevorzugt 9 Sensorelemente vorgesehen. Dies ermöglicht es, eine in Zeilenrichtung kurze Messvorrichtung zu bauen. Es sind Anwendungsgebiete bekannt, bei denen überprüft werden soll, ob ein an der Messvorrichtung vorbei bewegtes Messobjekt an einer bestimmten Stelle vorherbestimmte magnetische Eigenschaften aufweist. Bei diesen Anwendungsgebieten ist es möglich, dass Messobjekt so an der Messvorrichtung vorbeizuführen, dass das die zu ermittelnden magnetischen Eigenschaften hervorrufende Teilsegment des Messobjekts innerhalb eines klar definierten Bereichs an der Messvorrichtung vorbeigeführt werden kann. Dies erlaubt es, die Messvorrichtung schmal auszuführen. Beispielsweise kann die Erstreckung in Zeilenrichtung dem Toleranzbereich entsprechen, innerhalb dessen das die zu prüfenden Eigenschaften hervorrufende Teilsegment des Messobjekts definitiv geführt wird. Erkennt die Messvorrichtung keine dem Vorbeiführen eines solchen Teilsegments entsprechende Änderung der magnetischen Eigenschaften seiner Umgebung, so steht fest, dass das zu untersuchende Messobjekt die zu prüfenden magnetischen Eigenschaften nicht besitzt. Insbesondere für solche Anwendungsfälle eignet sich eine kompakt und einfach herzustellende und somit meist kostengünstige Messvorrichtung besonders.

Zur Bildung der Sensorzeile sind - soweit vorhanden - die Sensorelemente in einer Zeile angeordnet. Insbesondere bevorzugt liegen die Sensorelemente auf einer Linie. Es ist aber auch denkbar, dass die Sensorelemente einer einzelnen Zeile bezogen auf eine in Zeilenrichtung weisende Achse unterschiedlich angeordnet sind, sodass die Längsmittelachsen der Einzelsensoren nicht mehr alle auf einer Linie liegen. Insbesondere bevorzugt sind derart angeordnete Sensorelemente jedoch so angeordnet, dass sie sich in Richtung der Zeilenrichtung gesehen teilweise überlappen.

In einer bevorzugten Ausführungsform sind mehrere Sensorelemente zu einer Baugruppe zusammengefasst, beispielsweise auf einer gemeinsamen Trägerstruktur, typischerweise einem Chip, angeordnet. Eine solche Baugruppe, sofern sie direkt auf einer Leiterplatte montiert wird, oder alternativ ein lötbares Elektronikgehäuse mit eingebauten Chip, wird nachfolgend als Sensor bezeichnet. In einer Ausführungsform ist der Sensor direkt auf dem Magneten angeordnet. Ein Sensor kann beispielsweise dadurch gebildet werden, dass ein Chip mehrere Sensorelemente aufweist. Ein Sensor kann beispielsweise zwei, drei, vier oder mehr Sensorelemente aufweisen. Es ist aber auch möglich, dass ein Sensor durch ein einziges Sensorelement gebildet wird.

Der Grundgedanke der Erfindung baut darauf auf, mit der Magnetisierungsvorrichtung ein magnetisches Feld zu erzeugen, das im Bereich der Sensorzeile im Wesentlichen homogen ist und dessen Feldrichtung im Bereich der Sensorzeile im Winkel zwischen 65° und 85° zur Zeilenrichtung weist. Das von der Magnetisierungsvorrichtung erzeugte magnetische Feld ist dabei das magnetische Feld, das auf die Sensorzeile wirkt, wenn mit Ausnahme der stets wirkenden, natürlichen Magnetfelder kein weiteres Magnetfeld auf die Sensorzeile wirkt, die Sensorzeile sich also noch nicht an ihrem Messort befindet. Diesem von der Magnetisierungsvorrichtung erzeugten magnetischen Felds kann sich am Messort, beispielsweise wenn ein zu prüfendes Wertdokument an der Sensorzeile vorbeigeführt wird, ein weiteres magnetisches Feld überlagern. Diese Überlagerung der beiden Felder ist beispielsweise die vorstehend als magnetische Eigenschaft der Umgebung definierte Änderung der Feldstärke, bzw. Feldrichtung.

In der Mehrzahl der Anwendungsfälle ist die zur Stützung der Sensorelemente notwendige Feldkomponente, also die in Zeilenrichtung weisende Feldkomponente des magnetischen Felds geringer, als die zur Vormagnetisierung und insbesondere zur Sättigung weichmagnetischer Strukturen notwendige Feldstärke, also die Feldstärke der senkrecht zur Zeilenrichtung weisenden Feldkomponente des magnetischen Feldes der Magnetisierungsvorrichtung. Deshalb ist in der beanspruchten Ausführungsform der Winkel zwischen der Feldrichtung des magnetischen Feldes der Magnetisierungsvorrichtung im Bereich der Sensorzeile zwischen 65° und 85° zur Zeilenrichtung. Da beim Einsatz von AMR-Sensoren die Stützfeldstärke in Zeilenrichtung empfindlichkeitsbestimmend wirkt, kann bei zu steilen Winkeln eine sehr große Abhängigkeit der Sensorempfindlichkeit von verbleibenden, konstruktiv und fertigungstechnisch bedingten Feldwinkelschwankungen bestehen, während bei zu flachen Winkeln die Sensorempfindlichkeit zu gering ist.

Das von der Magnetisierungsvorrichtung erzeugte magnetische Feld kann dazu verwendet werden, um weichmagnetische Strukturen zu sättigen und sie damit in einen Zustand zu bringen, dass ihre Existenz auf dem zu untersuchenden Messobjekt durch die Sensorzeile erfasst werden kann. Das magnetische Feld der Magnetisierungsvorrichtung kann jedoch auch dazu eingesetzt werden, hartmagnetische Strukturen definiert zu sättigen, um ein von früheren Magnetisierungen unabhängiges Sensorsignal zu erzeugen.

In einer bevorzugten Ausführungsform weist die Sensorzeile eine Länge, eine Breite sowie eine Höhe auf, wobei die Höhe geringer ist als die Breite und die Höhe geringer ist als die Länge, und bei der das von der Magnetisierungsvorrichtung erzeugte magnetische Feld im Bereich der Sensorzeile im Wesentlichen nur eine Feldkomponente in Richtung der Länge der Sensorzeile und eine Feldkomponente in Richtung der Höhe der Sensorzeile aufweist, im Bereich der Sensorzeile im Wesentlichen aber keine Feldkomponente in Richtung der Breite der Sensorzeile aufweist. In dieser bevorzugten Ausführungsform werden insbesondere Sensorelemente oder Verschaltungen von Sensorelementen eingesetzt, die auf einem magnetoresistiven Effekt beruhen und derart ausgeführt sind, dass sie die magnetische Feldkomponente in nur einer Messrichtung detektieren, bevorzugt der senkrecht zur Zeilenrichtung und nicht in Richtung der Höhe weisenden Richtung. Beispielsweise können magnetoresistive Sensoren eingesetzt werden, die in Planarer-Dünnschicht-Technologie gefertigt sind und die nahezu unempfindlich auf die Feldkomponente senkrecht zur Chipebene sind. Wird das magnetische Feld der Magnetisierungsvorrichtung so eingestellt, dass es im Wesentlichen keine Feldkomponente in Richtung der Breite der Sensorzeile aufweist, so können Sensoren, die nur in diese Messrichtung (in Richtung der Breite der Sensorzeile) empfindlich sind eingesetzt werden, ohne dass sie durch das magnetische Feld der Magnetisierungsvorrichtung gestört werden.

In einer bevorzugten Ausführungsform sind die die Sensorzeile bildenden Sensorelemente derart angeordnet und ausgebildet, dass sie im Wesentlichen nur in Zeilenrichtung die magnetischen Eigenschaften der Umgebung messen können. In einer alternativen Ausführungsform sind die die Sensorzeile bildenden Sensorelemente derart angeordnet und ausgebildet, dass sie im Wesentlichen nur in eine Richtung, die nicht die Zeilenrichtung und nicht die Richtung der Höhe der Sensorzeile ist, die magnetischen Eigenschaften der Umgebung messen können. In einer wiederum alternativen Ausführungsform sind die die Sensorzeile bildenden Sensorelemente derart angeordnet und ausgebildet, dass sie im Wesentlichen nur in einer als Sensorebene bezeichneten, durch zwei senkrechte Messrichtungen eines orthogonalen Koordinatensystems aufgespannten Ebene die magnetischen Eigenschaften ihrer Umgebung messen können, wobei die Zeilenrichtung eine dieser Messrichtungen ist und die Richtung der Breite der Sensorzeile die zweite dieser Messrichtungen ist.

In einer bevorzugten Ausführungsform weist die Magnetisierungsvorrichtung einen ersten Magneten auf, der in Zeilenrichtung im Bereich des einen Endes der Sensorzeile angeordnet ist, und einen zweiten Magneten, der in Zeilenrichtung im Bereich des gegenüberliegenden Endes der Sensorzeile angeordnet ist. Bei dieser Ausführungsform sind sowohl beim ersten Magneten als auch beim zweiten Magneten die den Nordpol mit dem Südpol verbindenden Linien in einem Winkel zwischen 65° und 85° zur Zeilenrichtung ausgerichtet. Zur Verbesserung der Feldhomogenität quer zur Zeilenlängsrichtung kann es zweckmäßig sein, jeden der beiden zuvor beschriebenen Magnete seinerseits in zwei beabstandete Magnete aufzuteilen.

In einer alternativen Ausführungsform weist die Magnetisierungsvorrichtung einen einzigen Magneten auf. In einer besonders bevorzugten Ausführungsform erstreckt sich der Magnet zumindest über die gesamte Länge der Sensorzeile in Zeilenrichtung. Der Magnet ist vorzugsweise so angeordnet, dass die seinen Nordpol mit seinem Südpol verbindende Linie in einem Winkel zwischen 65° und 85° zur Zeilenrichtung verläuft. Dabei muss die den Nordpol und Südpol verbindende Linie nicht zwingend im gleichen Winkel relativ zur Zeilenrichtung angeordnet sein, wie der Winkel der Feldrichtung des von der Magnetisierungsvorrichtung erzeugten magnetischen Feldes im Bereich der Sensorzeile. Die Ausführungsform, bei der die Magnetisierungsvorrichtung einen einzigen Magneten aufweist, erlaubt einen besonders kompakten und besonders einfachen Aufbau der Messvorrichtung.

In einer bevorzugten Ausführungsform ist in der der Sensorzeile zugewandten Oberfläche eines Magneten der Magnetisierungsvorrichtung eine zur Sensorzeile hin offene Kavität vorgesehen. Es hat sich gezeigt, dass bei Abweichungen von der - gemäß einer bevorzugten Ausführungsform auch einsetzbaren - Quaderform eines Magneten der Magnetisierungsvorrichtung besonders gut ein im Bereich der Sensorzeile im Wesentlichen homogenes magnetisches Feld mit einer im Bereich der Sensorzeile in einem Winkel zwischen 65° und 85° zur Sensorzeile ausgerichteten Feldrichtung erzeugt werden kann. Diese Ausführungsform wird insbesondere bevorzugt bei Magnetisierungsvorrichtungen eingesetzt, die einen einzigen Magneten aufweisen. Sie kann aber auch Vorteile bei Magnetisierungsvorrichtungen bieten, die mehrere Magnete aufweisen. In einer bevorzugten Ausführungsform ist die Kavität so ausgeführt, dass die zur Sensorzeile hin weisende Öffnung der Kavität größer ist, als die Fläche die die Sensorzeile mit ihren Sensorelementen selbst einnimmt.

In einer bevorzugten Ausführungsform ist die zur Sensorzeile hingewandte Öffnung der Kavität rechteckig ausgeführt. Insbesondere bevorzugt erstreckt sich die Länge der Öffnung in Zeilenrichtung und ist größer als die sich senkrecht zur Zeilenrichtung erstreckende Breite der Öffnung. Es hat sich gezeigt, dass mit einer derartigen Kavität besonders gut ein im Bereich der Sensorzeile im Wesentlichen homogenes magnetisches Feld erzeugt werden kann, dessen Feldrichtung im Bereich der Sensorzeile in einem Winkel zwischen 65° und 85° zur Zeilenrichtung weist. In einer bevorzugten Ausführungsform weist die Kavität unterschiedliche Tiefen auf. Es hat sich gezeigt, dass mit einer derartigen Kavität besonders gut ein im Bereich der Sensorzeile im Wesentlichen homogenes magnetisches Feld erzeugt werden kann, dessen Feldrichtung im Bereich der Sensorzeile in einem Winkel zwischen 65° und 85° zur Zeilenrichtung weist. In einer bevorzugten Ausführungsform weist die Kavität einen mittleren Bereich mit einer größeren Tiefe auf und in Zeilenrichtung neben dem mittleren Bereich angeordnete Seitenbereiche, die eine geringere Tiefe aufweisen.

In einer bevorzugten Ausführungsform weist die Kavität der Öffnung gegenüberliegende Grundflächen auf, die insbesondere bevorzugt in zur Ebene der Öffnung parallelen Ebenen angeordnet sind. In einer besonders bevorzugten Ausführungsform ist jede Grundfläche der Kavität rechteckig. Zum Erzeugen einer Ausführungsform mit unterschiedlicher Tiefe können die einzelnen Grundflächen unterschiedlich weit von der Ebene der Öffnung entfernt angeordnet sein. In einer bevorzugten Ausführungsform weist die Kavität eine mittlere, weiter von der Ebene der Öffnung entfernte Grundfläche und jeweils eine in die eine, bzw. in die entgegengesetzte Richtung der Zeilenrichtung neben dieser Grundfläche angeordnete Grundfläche auf, die weniger weit von der Ebene der Öffnung entfernt ist. In einer bevorzugten Ausführungsform ist der Querschnitt der Kavität bezüglich einer Ebene, die die Zeilenrichtung und eine Senkrechte zur Ebene der Öffnung enthält, spiegelsymmetrisch. Eine derartige Ausbildung der Kavität ermöglicht es besonders gut, ein im Bereich der Sensorzeile im Wesentlichen homogenes magnetisches Feld zu erzeugen, dessen Feldrichtung im Bereich der Sensorzeile in einem Winkel zwischen 65° und 85° zur Zeilenrichtung aufweist.

In einer bevorzugten Ausführungsform sind die Sensorelemente unmittelbar oder die die Sensorelemente tragenden Chips oder die die Chips beinhaltenden Gehäuse auf einer Seite eine Leiterplatte befestigt und die Messvorrichtung auf der gegenüberliegenden Seite der Leiterplatte angeordnet, insbesondere bevorzugt an der Leiterplatte befestigt. Diese Ausführungsform erlaubt es, die Sensorelemente dem zu untersuchenden Messobjekt, insbesondere dem Wertdokument, besonders nahe zu bringen, bzw. die Messebene, in der das zu untersuchende Objekt in einer bevorzugten Ausführungsform bewegt wird, nahe an die Oberfläche der Sensorelemente zu bringen.

In einer bevorzugten Ausführungsform ist ein weiteres, nicht in der Sensorzeile angeordnetes Sensorelement vorgesehen, das die magnetischen Eigenschaften seiner Umgebung messen kann. Dieses weitere Sensorelement ist insbesondere bevorzugt zwischen der Magnetisierungsvorrichtung und der Sensorzeile oder auf der der Sensorzeile gegenüberliegenden Seite der Magnetisierungsvorrichtung angeordnet. In einer entsprechenden Ausführungsform kann das weitere Sensorelement auch in einer Kavität eines eine Kavität aufweisenden Magneten der Magnetisierungsvorrichtung angeordnet sein. Das Vorsehen eines weiteren Sensors erlaubt es, Störfelder zu messen, deren Ursprung nicht in den von der Sensorzeile zu messenden magnetischen Eigenschaften der Umgebung der Sensorzeile bedingt liegen, insbesondere bevorzugt nicht durch das in einer bevorzugten Ausführungsform zu untersuchende Wertdokument erzeugt werden. Der Einsatz eines solchen weiteren Sensorelements erlaubt es, aus dem von der Sensorzeile erzeugten Signal den Anteil zu eliminieren, der Störfeldern zuzurechnen ist.

In einer bevorzugten Ausführungsform weist die Messvorrichtung eine Auswerteeinrichtung auf. Insbesondere bevorzugt weisen zunächst zwei, insbesondere bevorzugt alle Sensorelemente eine Ausgangssignalleitung auf, wobei in dieser bevorzugten Ausführungsform die Ausgangssignalleitungen der Sensorelemente der Auswerteeinrichtung zugeführt werden können. In einer besonders bevorzugten Ausführungsform kann die Auswerteeinrichtung pro Zeiteinheit den Mittelwert aus den Signalen der Ausgangssignalleitung aller Sensorelemente bilden. Diese Ausführungsform eignet sich besonders für die Anwendungsfälle der erfindungsgemäßen Messvorrichtung, bei denen lediglich die Frage des Vorhandenseins einer magnetischen Eigenschaft auf einem zu untersuchenden Messobjekt überprüft werden soll, ohne beispielsweise die konkrete Lage eines diese magnetische Eigenschaft hervorrufenden Teilbereichs auf dem Messobjekt festzustellen.

In einer bevorzugten Ausführungsform sind die Sensorelemente in Zeilenrichtung äquidistant angeordnet. In einer besonders bevorzugten Ausführungsform beträgt der Abstand eines ersten Sensorelements zu einem benachbarten Sensorelement, bezogen auf den Abstand zwischen den Mittelpunkten der beiden Sensorelemente, zwischen 1 und 10 mm, vorzugsweise zwischen 2 und 5 mm und insbesondere bevorzugt 3,5 mm. In einer besonders bevorzugten Ausführungsform weist ein Chip zwei in Zeilenrichtung nach einander angeordnete Sensorelemente auf und weist - ohne Gehäuse - eine Länge von 1 ,5 bis 9 mm, vorzugsweise von 2 bis 3 mm und insbesondere bevorzugt von 2,5 mm in Zeilenrichtung auf. In einer bevorzugten Ausführungsform beträgt der Abstand von einem Rand eines Chips zu dem Rand des benachbarten Chips weniger als 1 ,5 mm und insbesondere bevorzugt weniger als 1 ,1 mm.

In einer alternativen Ausführungsform sind die Sensorelemente derart angeordnet, dass der Abstand zwischen zwei Rändern zweier benachbarter Sensorelemente, die auf einem Chip angeordnet sind, kleiner ist, als der Abstand zwischen zwei Rändern benachbarter Sensorelemente, die nicht auf einem Chip angeordnet sind. Der Abstand zwischen zwei Chips ist in der Regel durch die Technologie vorgegeben, mit der ein Chip auf einer Trägerplatte verbunden werden kann. Diese Technologien benötigen in der Regel mehr Raum als der Raum, der benötigt wird, um zwei magnetoresistive Sensorelemente auf einem Chip anzuordnen. Die Empfindlichkeit der Messvorrichtung kann deshalb dadurch gesteigert werden, dass sowohl die Anbringung der Sensorelemente auf dem Chip als auch die Anbringung der Chips auf dem Board so dicht wie nach der jeweils eingesetzten Technologie möglich erfolgt.

Die Herstellung der Sensorelemente auf den Chips erfolgt bevorzugt mit den Methoden der Planartechnik, Halbleitertechnik oder Mikrosystemtechnik.

In einer besonders bevorzugten Ausführungsform ist die Messvorrichtung dazu ausgebildet, magnetische Strukturen eines Scheins oder eines Bogens, insbesondere eines Geldscheins zu erkennen, und weist geeignete Mittel auf, um den Schein oder Bogen zumindest in einem der Sensorzeile benachbarten Bereich in einer Messebene an der Sensorzeile vorbei zu bewegen. Hierfür geeignete Mittel sind insbesondere Walzen, die einen Walzspalt zwischen sich bilden, in der der Schein oder der Bogen gehalten werden kann. Werden zwei Gruppen solcher Walzen verwendet und die zwischen den Walzen der jeweiligen Gruppe gebildeten Walzspalte entsprechend zueinander ausgerichtet, so kann ein Schein oder ein Bogen zwischen den beiden Walzengruppen in einer Ebene an der Sensorzeile vorbei bewegt werden. Ebenso kann der Schein oder Bogen auf einem Transportband, beispielsweise einem eine Gummioberfläche aufweisenden Transportband oder einem aus einem Fließ bestehenden Transportband liegend an der Sensorzeile vorbei bewegt werden.

In einer bevorzugten Ausführungsform weist die Messvorrichtung zwei Leiterplatten auf. Die beiden Leiterplatten sind insbesondere bevorzugt parallel zueinander angeordnet. In der bevorzugten Ausführungsform kann die erste Leiterplatte die Sensorelemente unmittelbar tragen, bzw. Chips tragen, die wiederum die Sensorelemente tragen. Auf der zweiten, insbesondere bevorzugt parallel zur ersten Leiterplatte angeordneten Leiterplatte kann ein weiteres, nicht in der Sensorzeile angeordnete Sensorelement vorgesehen sein. Ferner können auf dieser zweiten Leiterplatte Komponenten einer Auswerteeinrichtung, beispielsweise auch Vorverstärker für die Ausgangssignale der Sensorelemente vorgesehen sein. In einer bevorzugten Ausführungsform ist zwischen der ersten Leiterplatte und der zweiten Leiterplatte die Magnetisierungsvorrichtung angeordnet, insbesondere bevorzugt der bei einer bevorzugten Ausführungsform vorgesehene einzige Magnet der Magnetisierungsvorrichtung. In einer entsprechend ausgebildeten, bevorzugten Ausführungsform weist eine in dem Magneten vorgesehene Kavität mit ihrer Öffnung zur Sensorzeile hin. Die auf den jeweiligen Leiterplatten vorgesehenen Elemente können mittels einer flexiblen Verbindung miteinander verbunden werden. Im Ergebnis kann in dieser bevorzugten Ausführungsform eine kompakte, nahezu quaderförmige Messvorrichtung entstehen.

Ein mögliches Anwendungsgebiet der Erfindung ist das Prüfen von Scheinen oder Bögen, insbesondere von Geldscheinen, Schecks oder anderen Papierbögen auf das Vorhandensein magnetischer Merkmale, insbesondere daraufhin, ob die Scheine oder Bögen besondere, vorher festgelegte magnetische Merkmale aufweisen.

Die erfindungsgemäße Messvorrichtung kann Anwendung finden bei der Mustererkennung auf Wertdokumenten, wie beispielsweise Banknoten, Schecks, die häufig mit weichmagnetischen und/oder magnetischen Mustern versehen sind. Ebenso kann die erfindungsgemäße Vorrichtung bei dem Erkennen von so genannten Tags oder bei der Erkennung magnetischer Barcodes eingesetzt werden. Ebenso kann die erfindungsgemäße Messvorrichtung bei der Materialprüfung, wie beispielsweise beim Feststellen von Fehlstellen, Löchern oder Rissen in ferromagnetischen oder elektrisch leitfähigen Werkstoffen eingesetzt werden. Ebenfalls kann die erfindungsgemäße Messvorrichtung Anwendung bei magnetischen Arrays in Biochips oder bei der so genannten "Lab-on-a-Chip"-Technologie Einsatz finden, beispielsweise zum Nachweis magnetischer Beads oder zur Homogenisierung der Empfindlichkeitsverteilung des Arrays. Insbesondere kann die erfindungsgemäße Messvorrichtung als Ersatz für Induktivköpfe verwendet werden.

Nachfolgend wird die Erfindung anhand einer lediglich Ausführungsbeispiele der Erfindung darstellenden Zeichnung näher erläutert. Darin zeigen:
- Fiq.1:: eine schematische Seitenansicht auf die Sensorzeile und eine mit einem einzigen Magneten ausgebildete Magnetisierungsvorrichtung der erfindungsgemäßen Messvorrichtung als Querschnitt senkrecht zur Zeilenrichtung;
- Fig. 2:: eine schematische Frontansicht der in Fig. 1 dargestellten Bauelemente der erfindungsgemäßen Messvorrichtung als Querschnitt senkrecht zur Zeilenrichtung;
- Fig. 3:: eine schematische, perspektivische Ansicht des Magneten der Magnetisierungsvorrichtung der Ausführungsform der Fig. 1 und 2;
- Fig. 4:: eine schematische, perspektivische Ansicht von oben auf die erfindungsgemäße Messvorrichtung;
- Fig. 5:: eine schematische, perspektivische Ansicht von unten auf die erfindungsgemäße Messvorrichtung;
- Fig. 6:: eine schematische Seitenansicht auf die erfindungsgemäße Messvorrichtung;
- Fig. 7:: eine schematische Ansicht auf die Sensorzeile der erfindungsgemäßen Messvorrichtung;
- Fig. 8:: eine schematische Seitenansicht auf eine mit zwei getrennten Magneten aufgebaute erfindungsgemäße Messvorrichtung und
- Fig.9:: eine schematische, perspektivische Ansicht einer aus 4 Einzelmagneten aufgebauten, erfindungsgemäßen Messvorrichtung.

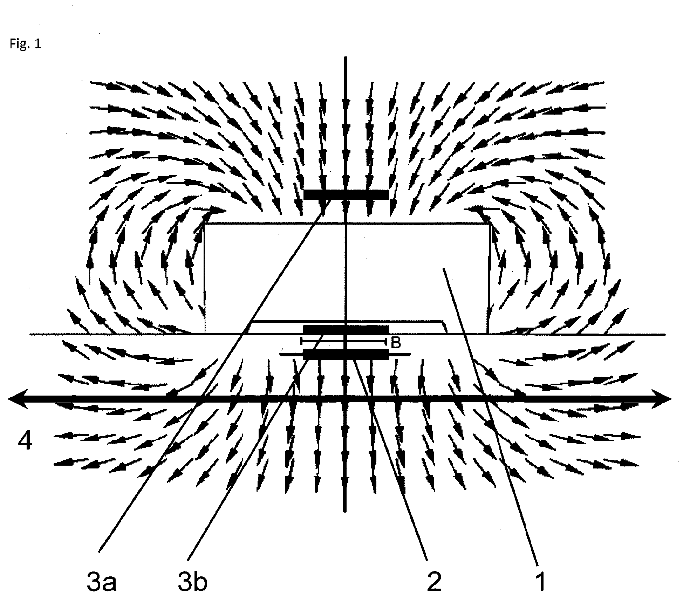

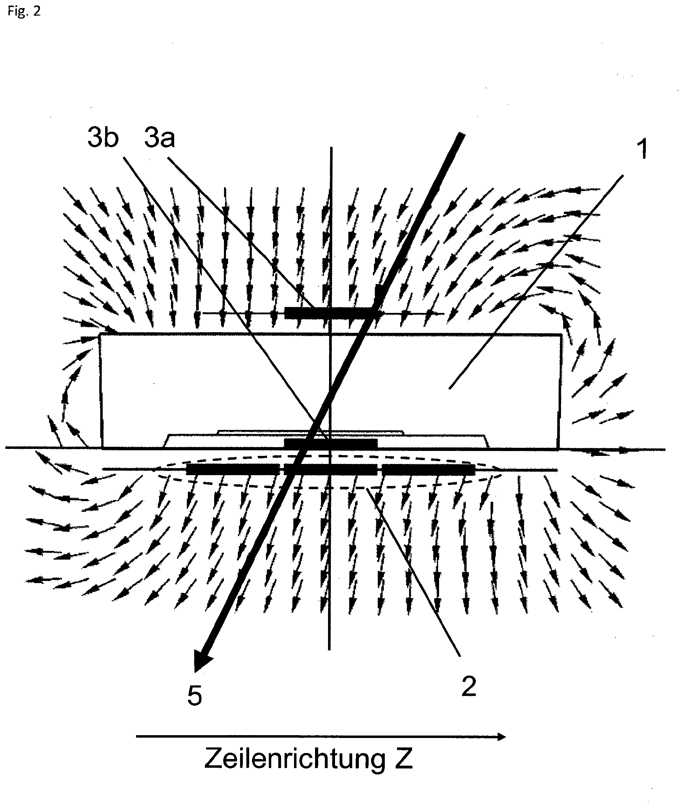

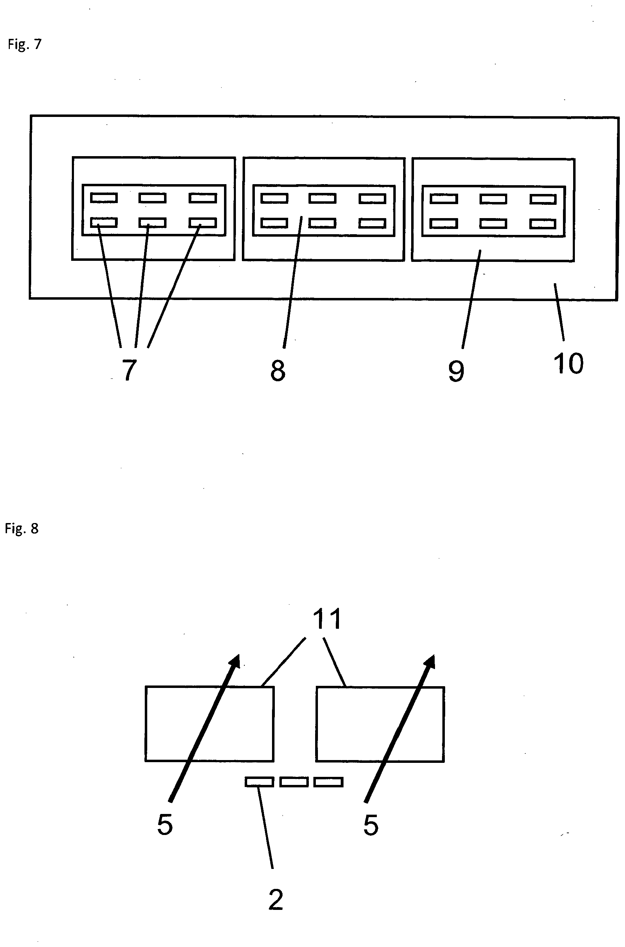

Die in den Figuren dargestellten Ausführungsformen der erfindungsgemäßen Messvorrichtung zum Messen magnetischer Eigenschaften der Umgebung der Messvorrichtung weisen eine Sensorzeile 2 mit mindestens zwei sich in eine Zeilenrichtung Z erstreckenden Sensorelementen 7 auf. Mit der Sensorzeile 2 können die magnetischen Eigenschaften der Umgebung der Messvorrichtung gemessen werden. Die erfindungsgemäße Messvorrichtung weist eine Magnetisierungsvorrichtung auf, die entweder (Fig. 1 - 6) einen einzigen Magneten 1 oder (Fig. 8) zwei Magnete 11 oder (Fig. 9) vier Magnete 11 aufweist. Die Figur 2 zeigt, dass das von der Magnetisierungsvorrichtung erzeugte magnetische Feld im Bereich der Sensorzeile im Wesentlichen homogen ist und seine Feldrichtung im Bereich der Sensorzeile in einem Winkel von α = 65° - 85° zur Zeilenrichtung Z weist. Die Figur 1 zeigt, dass das von der Magnetisierungsvorrichtung erzeugte magnetische Feld im Wesentlichen keine Feldkomponente hat, die senkrecht zur Zeilenrichtung in Richtung der Breite B der Sensorelemente weist.

Die Figuren 1 bis 6 zeigen, dass die Magnetisierungsvorrichtung einen einzigen Magneten 1 aufweist. Die Figur 2 zeigt, dass sich die Länge des Magneten 1 über die Länge der Sensorzeile hinaus erstreckt.

In dem einzigen Magneten 1 der Magnetisierungsvorrichtung ist in seiner der Sensorzeile 2 zugewandten Oberfläche eine zur Sensorzeile offene Kavität 14 vorgesehen (Fig. 3). Die Kavität 14 hat eine im Wesentlichen rechteckige Öffnung. Ferner hat die Kavität 14 eine mittig angeordnete Grundfläche 6 und zwei jeweils in Zeilenrichtung neben der Grundfläche 6 angeordneten weiteren Grundflächen 12, 13 (vgl. Figur 3). In der perspektivischen Ansicht der Figur 3 erkennt man ferner, dass die Tiefe der Kavität im Bereich der mittleren Grundfläche 6 tiefer ist, als im Bereich der daneben angeordneten Grundflächen 12, 13.

In der Figur 3 ist ferner zu erkennen, dass der Querschnitt der Kavität 14 in einer Ebene E1, die auch die Zeilenrichtung Z enthält und senkrecht zur Ebene der Kavität steht, spiegelsymmetrisch ist.

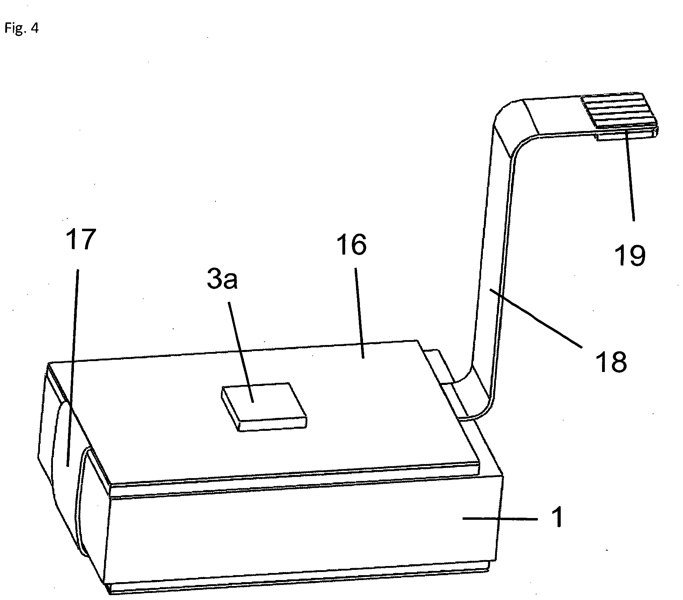

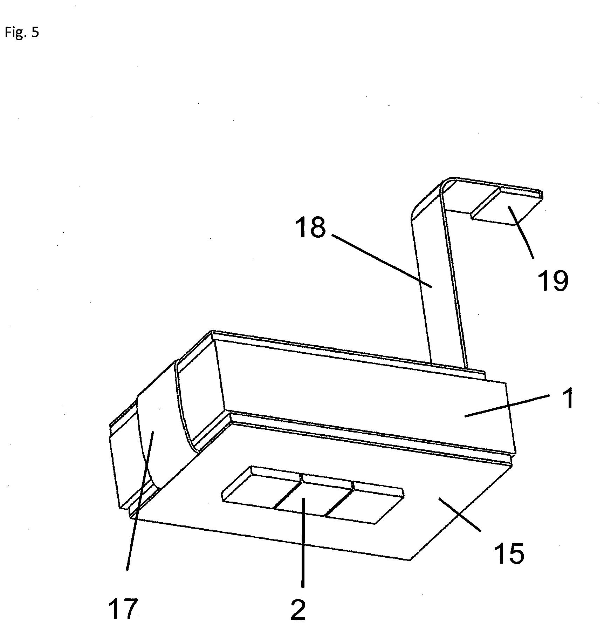

Die Figuren 4, 5, 6 zeigen, dass die erfindungsgemäße Messvorrichtung zwei starre, durch einen flexiblen Abschnitt 17 verbundene starre Leiterplattenteile aufweist. Die Figur 5 zeigt, dass die die Sensorelemente beinhaltenden Sensorgehäuse in der Sensorzeile 2 an einem ersten Leiterplattenteil 15 befestigt sind. Die Figur 4 zeigt, einen weiteren, nicht in der Sensorzeile 2 angeordneter Sensor 3a, der weitere Sensorelemente beinhaltet und an einem zweiten Leiterplattenteil 16 befestigt ist. Den Figuren 4, 5 und 6 ist ferner zu entnehmen, dass der einzige Magnet 1 der Magnetisierungsvorrichtung zwischen den parallel angeordneten Leiterplattenteilen 15, 16 angeordnet ist. Ferner zeigen die Figuren 4, 5 und 6 dass eine Flexverbindung 17 den ersten Leiterplattenteil 15 mit dem zweiten Leiterplattenteil 16 verbindet. Eine zweite Flexverbindung 18 verbindet den zweiten Leiterplattenteil 16 mit einem Anschlussstecker 19.

Die Figuren 1 und 2 zeigen, dass weitere, nicht in der Sensorzeile angeordnete Sensorelemente 3a, 3b vorgesehen sein können, die die magnetischen Eigenschaften ihrer Umgebung messen können. Das weitere Sensorelement 3b ist in der Kavität des Magneten 1 angeordnet. Das weitere Sensorelement 3a ist auf der der Sensorzeile gegenüberliegenden Seite der Magnetisierungsvorrichtung angeordnet. Die weiteren Sensorelemente 3a, 3b können auch alternativ zueinander vorgesehen sein oder können in anderen Ausführungsformen der Erfindung auch weggelassen werden.

Auf der Leiterplatte 16 können weitere Bauelemente einer Auswerteeinrichtung vorgesehen sein. Über die Flexverbindung 17 können Ausgangssignalleitungen der Sensorelemente mit diesen Bauelementen einer Auswerteeinrichtung verbunden werden. Die Auswerteeinrichtung kann dann pro Zeiteinheit den Mittelwert aus den Signalen der Ausgangssignalleitungen der Sensorelemente der Sensorzeile bilden und/oder die Signale vorverstärken und/oder eine Digitalisierung vornehmen.

Die Figur 7 zeigt schematisch den typischen Aufbau einer erfindungsgemäßen Sensorzeile 2 aus auf eine Leiterplatte 10 aufgelöteten Sensorgehäusen 9, die jeweils einen Chip 8 enthalten, welcher wiederum Träger einer Anzahl von magnetfeldempfindlichen Sensorelementen 7 ist.

Die Figur 8 zeigt eine erfindungsgemäße Ausführungsform, bei der statt einem Einzelmagneten zwei schräg magnetisierte Magnete 11 für die Erzeugung eines insbesondere in Zeilenlängsrichtung homogenen Stütz- und Vormagnetisierfeldes im Bereich der Sensorzeile 2 verwendet werden.

Die Figur 9 zeigt eine weitere Ausführungsform, bei der durch eine weitere Aufteilung der beiden Magnete aus Fig. 8 in zusammen 4 Magnete 11 eine weitere Homogenisierung des Feldes im Zeilenbereich in der Richtung quer zu Zeilenlängsrichtung erreicht wird.

## Patentansprüche

1. Messvorrichtung zum Messen magnetischer Eigenschaften der Umgebung der Messvorrichtung mit einer Sensorzeile (2) mit mindestens zwei sich in eine Zeilenrichtung (Z) erstreckenden Sensorelementen (7), wobei mit der Sensorzeile die magnetischen Eigenschaften ihrer Umgebung gemessen werden können und wobei die Sensorelemente ein AMR-Sensor sind, **gekennzeichnet durch** eine Magnetisierungsvorrichtung, die ein magnetisches Feld erzeugt, das im Bereich der Sensorzeile (2) im Wesentlichen homogen ist und dessen Feldrichtung im Bereich der Sensorzeile (2) in einem Winkel zwischen 65° und 85° zur Zeilenrichtung (Z) weist.

2. Messvorrichtung nach Anspruch 1, **dadurch gekennzeichnet, dass** die Sensorzeile (2) eine Länge, eine Breite sowie eine Höhe aufweist, wobei die Höhe geringer ist als die Breite und die Höhe geringer ist als die Länge, wobei das von der Magnetisierungsvorrichtung erzeugte magnetische Feld im Bereich der Sensorzeile (2) im Wesentlichen nur eine Feldkomponente in Richtung der Länge der Sensorzeile (2) und eine Feldkomponente in Richtung der Höhe der Sensorzeile, im Bereich der Sensorzeile (2) im Wesentlichen aber keine Feldkomponente in Richtung der Breite der Sensorzeile (2) aufweist.

3. Messvorrichtung nach Anspruch 1 oder 2, **dadurch gekennzeichnet, dass** die Magnetisierungsvorrichtung einen ersten Magneten aufweist, der in Zeilenrichtung im Bereich des einen Endes der Sensorzeile angeordnet ist, und einen zweiten Magneten aufweist, der in Zeilenrichtung im Bereich des gegenüberliegenden Endes der Sensorzeile angeordnet ist, und sowohl beim ersten Magneten als auch beim zweiten Magneten die Magnetisierungsrichtungen einem Winkel zwischen 65° und 85° zur Zeilenrichtung verläuft.

4. Messvorrichtung nach Anspruch 3, **dadurch gekennzeichnet, dass** der erste Magnet durch zwei durch einen Zwischenraum getrennte Einzelmagnete und der zweite Magnet durch zwei durch einen Zwischenraum getrennte Einzelmagnete gebildet wird.

5. Messvorrichtung nach Anspruch 1 oder 2, **dadurch gekennzeichnet, dass** die Magnetisierungsvorrichtung einen einzigen Magneten (1) aufweist, der sich zumindest über die gesamte Länge der Sensorzeile in Zeilenrichtung erstreckt und der so angeordnet ist, dass die seinen Nordpol mit seinem Südpol verbindende Linie in einem Winkel zwischen 65° und 85° zur Zeilenrichtung (Z) verläuft

6. Messvorrichtung nach Anspruch 5, **dadurch gekennzeichnet, dass** in der der Sensorzeile (2) zugewandten Oberfläche des Magneten eine zur Sensorzeile hin offene Kavität (14) vorgesehen ist.

7. Messvorrichtung nach Anspruch 6, **dadurch gekennzeichnet, dass** die zur Sensorzeile (2) hin gewandte Öffnung der Kavität (14) rechteckig ist und die sich in Zeilenrichtung (Z) erstreckende Länge der Öffnung länger ist, als die sich senkrecht zur Zeilenrichtung (Z) erstreckende Breite der Öffnung.

8. Messvorrichtung nach Anspruch 6 oder 7, **dadurch gekennzeichnet, dass** die Kavität (14) unterschiedliche Tiefen aufweist.

9. Messvorrichtung nach einem der Ansprüche 6 bis 8, **dadurch gekennzeichnet, dass** der Querschnitt der Kavität (14) bezüglich einer Ebene (E1), die die Zeilenrichtung (Z) enthält, spiegelsymmetrisch ist.

10. Messvorrichtung nach einem der Ansprüche 1 bis 9, **dadurch gekennzeichnet, dass** die Sensorelemente (7) unmittelbar oder die die Sensorelemente tragenden Chips (8) oder die die Sensorchips beinhaltenden Gehäuse (9) auf einer Seite einer Leiterplatte (15) befestigt sind und die Magnetisierungsvorrichtung auf der gegenüberliegenden Seite der Leiterplatte (15) angeordnet, insbesondere bevorzugt an der Leiterplatte (15) befestigt ist.

11. Messvorrichtung nach einem der Ansprüche 1 bis 10, **gekennzeichnet durch** ein weiteres, nicht in der Sensorzeile angeordnetes Sensorelement (3a, 3b), das die magnetischen Eigenschaften seiner Umgebung messen kann, das zwischen der Magnetisierungsvorrichtung und der Sensorzeile oder auf der der Sensorzeile gegenüberliegenden Seite der Magnetisierungsvorrichtung oder bei einem eine Kavität (14) aufweisenden Magneten (1) der Magnetisierungsvorrichtung in der Kavität (14) angeordnet ist.

12. Messvorrichtung nach einem der Ansprüche 1 bis 11, **gekennzeichnet durch** eine Auswerteeinrichtung, wobei zumindest zwei Sensorelemente der Sensorzeile eine Ausgangssignalleitung aufweisen und die Ausgangssignalleitungen der Sensorelemente der Sensorzeile der Auswerteeinrichtung zugeführt werden und die Auswerteeinrichtung pro Zeiteinheit den Mittelwert aus den Signalen der Ausgangssignalleitungen der Sensorelemente der Sensorzeile bildet.

13. Verwendung der Messvorrichtung nach einem der Ansprüche 1 bis 12 zum Prüfen von Scheinen oder Bögen, insbesondere von Geldscheinen, Schecks oder anderen Papierbogen auf das Vorhandensein magnetischer Merkmale, insbesondere daraufhin, ob die Scheine oder Bögen besondere, vorher festgelegte magnetische Merkmale aufweisen.

## Claims

1. Measuring device for measuring magnetic properties of the surroundings of the measuring device with a sensor line (2) with at least two sensor elements (7) extending in a line direction (Z), wherein the magnetic properties of its surroundings can be measured with the sensor line and wherein the sensor elements are an AMR sensor, **characterised by** a magnetising device which creates a magnetic field which is essentially homogeneous in the area of the sensor line (2) and whose field direction in the area of the sensor line (2) points in an angle between 65° and 85° to the line direction (Z).

2. Measuring device according to claim 1, **characterised in that** the sensor line (2) has a length, a width and a height wherein the height is less than the width and the height is less than the length, wherein the magnetic field generated by the magnetising device in the area of the sensor line (2) essentially has just one field component in the direction of the length of the sensor line (2) and a field component in the direction of the height the sensor line essentially in the area of the sensor line (2) but no field component in the direction of the width of the sensor line (2).

3. Measuring device according to claim 1 or 2, **characterised in that** the magnetising device has a first magnet which is arranged in the line direction in the area of one end of the sensor line and has a second magnet which is arranged in the line direction in the area of the opposite end of the sensor line, and the magnetising directions run at an angle between 65° and 85° to the line direction, both with the first magnet as well as with the second magnet.

4. Measuring device according to claim 3, **characterised in that** the first magnet is formed by two single magnets separated by an intermediate space and the second magnet is separated by two single magnets separated by an intermediate space.

5. Measuring device according to claims 1 or 2, **characterised in that** the magnetising device has a single magnet (1) which extends over the entire length of the sensor line in the line direction and is arranged such that the line connecting its north pole with its south pole runs at an angle between 65° and 85° to the line direction (Z).

6. Measuring device according to claim 5, **characterised in that** a cavity (14) opening towards the sensor line is provided in the surface of the magnet facing the sensor line (2).

7. Measuring device according to claim 6, **characterised in that** the opening of the cavity (14) turned towards the sensor line (2) is rectangular and the length of the opening extending in line direction (Z) is longer than the width of the opening extending perpendicular to the line direction (Z).

8. Measuring device according to claim 6 or 7, **characterised in that** the cavity (14) has varying depths.

9. Measuring device according to any one of claims 6 to 8, **characterised in that** the cross section of the cavity (14) with respect to a plane (E1) enclosing the line direction (Z), is symmetrically identical.

10. Measuring device according to any one of claims 1 to 9, **characterised in that** the sensor element (7) is directly attached or the chips (8) carrying the sensor elements or the housing (9) containing the sensor chips are arranged on one side of a circuit board (15) and the magnetising device is arranged on the opposite side of the circuit board (15), in particular preferably attached to the circuit board (15).

11. Measuring device according to any one of claims 1 to 10, **characterised by** a further sensor element (3a, 3b), not arranged in the sensor line, which can measure the magnetic properties of its surroundings, which is arranged between the magnetising device and the sensor line or on the side of the magnetising device opposite the sensor line or is arranged in the cavity (14) with a magnet (1) of the magnetising device having a cavity (14).

12. Measuring device according to any one of claims 1 to 11, **characterised by** an evaluation arrangement, wherein at least two sensor elements of the sensor line have an output signal line and the output signal lines are supplied to the sensor elements of the sensor line of the evaluation arrangement and the evaluation arrangement forms the mean value from the signals of the outgoing signal lines of the sensor elements of the sensor line per unit of time.

13. Application of the measuring device according to any one of claims 1 to 12 for verifying certificates or sheets, in particular bank notes, cheques or other sheets of paper for the presence of magnetic features, in particular whether the certificates or sheets contain in particular previously assigned magnetic features.

## Revendications

1. Dispositif de mesure pour mesurer les propriétés magnétiques de l'environnement du dispositif de mesure avec une ligne de capteur (2) comportant au moins deux éléments de capteur (7) s'étendant dans une direction de ligne (Z), dans lequel la ligne de capteur est capable de mesurer les propriétés magnétiques de son environnement et dans lequel les éléments de capteur sont un capteur AMR, **caractérisé par** un dispositif d'aimantation qui génère un champ magnétique qui est essentiellement homogène dans la zone de ligne de capteur (2) et dont la direction de champ dans la zone de ligne de capteur (2) est à un angle compris entre 65 ° et 85 ° par rapport à la direction de ligne (Z).

2. Dispositif de mesure selon la revendication 1, **caractérisé en ce que** la ligne de capteur (2) présente une longueur, une largeur et une hauteur, dans lequel la hauteur est inférieure à la largeur et la hauteur est inférieure à la longueur, dans lequel le champ magnétique généré par le dispositif d'aimantation dans la zone de la ligne de capteur (2) présente essentiellement une seule composante de champ dans la direction de la longueur de la ligne de capteur (2) et une composante de champ dans la direction de la hauteur de la ligne de capteur, dans la zone de la ligne de capteur (2) essentiellement mais pas de composante de champ dans la direction de la largeur de la ligne de capteur (2).

3. Dispositif de mesure selon la revendication 1 ou 2, **caractérisé en ce que** le dispositif d'aimantation présente un premier aimant qui est disposé dans la direction de ligne dans la zone d'une extrémité de la ligne de capteur, et présente un deuxième aimant qui est disposé dans la direction de ligne dans la zone de l'extrémité opposée de la ligne de capteur, et tant sur le premier aimant que le deuxième aimant, les directions de magnétisation s'étendent à un angle compris entre 65 ° et 85 ° par rapport à la direction de ligne.

4. Dispositif de mesure selon la revendication 3, **caractérisé en ce que** le premier aimant est formé de deux aimants individuels séparés par un espace intermédiaire et le deuxième aimant est formé de deux aimants individuels séparés par un espace intermédiaire.

5. Dispositif de mesure selon la revendication 1 ou 2, **caractérisé en ce que** le dispositif d'aimantation comporte un seul aimant (1) qui s'étend au moins sur toute la longueur de la ligne de capteur dans la direction de ligne et qui est agencé de sorte que la ligne reliant son pôle nord à son pôle sud s'étende dans un angle entre 65 ° et 85 ° par rapport à la direction de lignes (Z).

6. Dispositif de mesure selon la revendication 5, **caractérisé en ce qu'**une cavité (14) ouverte vers la ligne de capteur est prévue dans la surface de l'aimant tournée vers la ligne de capteur (2).

7. Dispositif de mesure selon la revendication 6, **caractérisé en ce que** l'ouverture de la cavité (14) tournée vers la ligne de capteur (2) est rectangulaire et la longueur de l'ouverture s'étendant dans la direction de ligne (Z) est plus longue que la largeur de l'ouverture s'étendant perpendiculairement à la direction de ligne (Z).

8. Dispositif de mesure selon la revendication 6 ou 7, **caractérisé en ce que** la cavité (14) présente des profondeurs différentes.

9. Dispositif de mesure selon une des revendications 6 à 8, **caractérisé en ce que** la section transversale de la cavité (14) est symétrique par rapport à un plan (E1) qui contient la direction de ligne (Z).

10. Dispositif de mesure selon une des revendications 1 à 9, **caractérisé en ce que** les éléments de capteur (7) ou les puces (8) portant les éléments de capteur ou les boîtiers (9) contenant les puces de capteurs sont fixés directement sur un côté d'une carte de circuit imprimé (15) et le dispositif d'aimantation est disposé sur le côté opposé de la carte de circuit imprimé (15), en particulier de préférence fixé à la carte de circuit imprimé (15).

11. Dispositif de mesure selon une des revendications 1 à 10, **caractérisé par** un autre élément non disposé dans la ligne de capteur (3a, 3b), qui peut mesurer les propriétés magnétiques de son environnement, qui est disposé entre le dispositif d'aimantation et la ligne de capteur ou sur le côté opposé du dispositif d'aimantation de la ligne de capteur ou dans le cas d'un aimant (1) du dispositif d'aimantation présentant une cavité (14) dans la cavité (14).

12. Dispositif de mesure selon une des revendications 1 à 11, **caractérisé par** un dispositif d'évaluation, dans lequel au moins deux éléments de capteur de la ligne de capteur présentent une ligne de signaux de sortie et les lignes de signaux de sortie des éléments de capteur de la ligne de capteurs sont introduits dans le dispositif d'évaluation et le dispositif d'évaluation par unité de temps forme d'après la valeur moyenne des signaux des lignes de signaux de sortie des éléments de capteur de la ligne de capteur.

13. Utilisation du dispositif de mesure selon une des revendications 1 à 12 pour contrôler des billets ou des feuilles, en particulier des billets de banque, des chèques ou d'autres feuilles de papier, afin de rechercher la présence de caractéristiques magnétiques, en particulier si les billets ou les feuilles présentent des caractéristiques magnétiques spéciales, prédéterminées.
